# EUROPEAN PATENT SPECIFICATION

(11) **EP 0 544 048 B1**
(45) Date of publication and mention of the grant of the patent: **18.06.1997**
(21) Application number: 91830513.7
(22) Date of filing: 25.11.1991
(51) Int. Cl.: H01L 27/06, H01L 27/082, H01L 21/76

(54) **Integrated bridge device optimising conduction power losses**
Integrierte Brückenanordnung mit optimierten Übertragungsleistungsverlusten
Dispositif integré en pont optimisant les pertes en puissance de conduction

(43) Date of publication of application: 02.06.1993
(73) Proprietor: SGS-THOMSON MICROELECTRONICS s.r.l., 20041 Agrate Brianza (Milano) (IT); CONSORZIO PER LA RICERCA SULLA MICROELETTRONICA NEL MEZZOGIORNO, 95121 Catania (IT)
(72) Inventor: Paparo, Mario, I-95037 San Giovanni la Punta (Catania) (IT); Aiello, Natale, I-95123 Catania (IT)
(74) Representative: Mittler, Enrico

(56) References cited:
- DE-A- 3 400 973
- US-A- 3 590 345
- PATENT ABSTRACTS OF JAPAN vol. 8, no. 281 (E-286)(1718) 21 December 1984 & JP-A-59 149 046
- INTERNATIONAL ELECTRON DEVICES MEETING 1987 6 December 1987, WASHINGTON, USA pages 766-769; C-CONTIERO ET AL.: "Design of a high side driver in multipower-BCD and vipower technologies."

## Description

This invention relates to an integrated bridge device which optimises conduction power losses.

When converting an electrical signal from alternating to direct current a Graetz bridge rectifier circuit consisting of two arms or half bridges each comprising two diode connected transistors in series is generally used. Examples of Graetz bridge rectifier circuits are shown in DE-A- 3400973.

One of the possible applications of this circuit is for example the making of a connection between the electronic circuits of a subscriber's telephone set and a two wire telephone line.

Although this circuit is commonly used, it has not been possible hitherto to construct it on a single silicon plate with reasonable conversion efficiencies using traditional integration technology.

When constructed in the form of an integrated circuit, parasitic transistors which cause considerable power losses are formed between the two arms of the bridge.

JP-A- 59149046 discloses a structure for preventing fixing of a parasitic thyristor by use of suitable bias.

The object of this invention is to provide a Graetz bridge device which is integrated monolithically on a single plate of semiconducting material which operates at high current, is robust and has a high conversion efficiency.

In accordance with the invention this object is achieved through an integrated bridge device structure as defined in claim 1.

Between the said type P, P+ regions there are also preferably second regions of type P and P+ respectively for recovery of the residual current loss of said parasitic transistors.

In this way the effect of the parasitic transistors which are formed between the type P, P+ regions of the first and the second arm of the bridge through the effect of integrated monolithic construction is reduced. In particular there is a reduction in the dissipated power and a reduction in the voltage drop across the diode transistors forming the two arms of the bridge.

The features of this invention will be more clear from a practical embodiment illustrated by way of a non-restrictive example in the appended drawings in which:
Figure 1 shows a prior art integrated bipolar embodiment of a Graetz bridge device,
Figure 2 shows the equivalent circuit diagram of the bipolar construction in Figure 1,
Figure 3 shows a bipolar integrated embodiment of the Graetz bridge device according to the invention,
Figure 4 shows another integrated embodiment of the device according to the invention as an alternative to that in Figure 3,
Figure 5 shows a mixed bipolar MOS integrated embodiment of the device according to the invention,
Figure 6 shows the equivalent circuit diagram of the mixed bipolar-MOS construction in Figure 5.

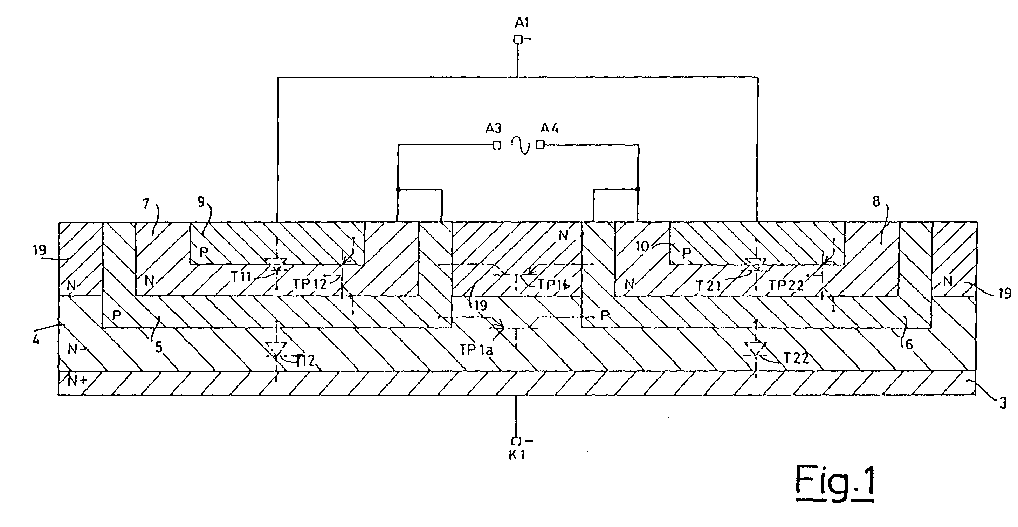

With reference to Figure 1, this illustrates a prior art integrated bipolar embodiment of a Graetz bridge rectifier circuit comprising a type N+ substrate 3 forming a positive potential output terminal K1, a type N- epitaxial layer 4, a type N surface epitaxial layer 19 and for each of the two arms 1, 2 of the bridge a type P region 5, 6 formed in epitaxial layers 4, 19. Within regions 5, 6 there are regions 7, 8 of type N, which are respectively short-circuited (in a manner which is not shown) with regions 5 and 6, and type P regions 9, 10 within them.

Region 9 represents the emitter of a first transistor T11 of arm 1, as well as the anode of an equivalent diode formed by T11 through the effect of short-circuiting regions 5 and 7 which form the collector and the base of transistor T11 and therefore the cathode of the aforementioned equivalent diode.

Region 5 also shows the base of a second transistor T12 of arm 1, together with the anode of an equivalent diode constructed from T12 by the effect of short-circuiting regions 5 and 7 which form the base and emitter of transistor T12. The collector of transistor T12, and therefore the cathode of the aforesaid equivalent diode, is formed by regions 3, 4.

Region 10 10 represents the emitter of a first transistor T21 of arm 2, as well as the anode of an equivalent diode constructed from T21 by the effect of short-circuiting regions 6 and 8 which form the collector and the base of transistor T21 and therefore the cathode of the aforesaid equivalent diode.

Region 6 also represents the base of a second transistor T22 of arm 2, as well as the anode of an equivalent diode formed from T22 by the effect of short-circuiting regions 6 and 8 which form the base and emitter of transistor T22. The collector of transistor T22 and therefore the cathode of the aforesaid equivalent diode is formed by regions 3, 4.

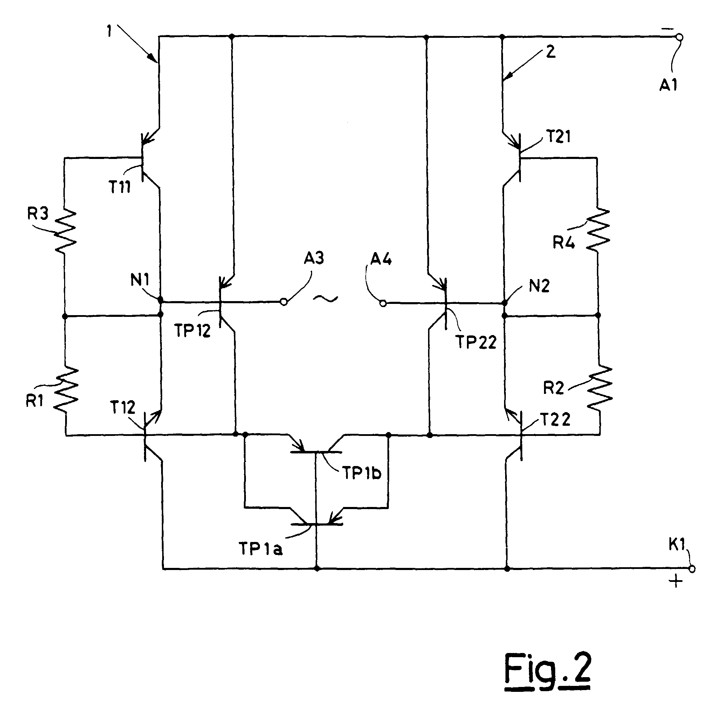

The equivalent electrical circuit of the integrated structure in Figure 1 is shown in Figure 2 and comprises two arms or half-bridges 1, 2 each consisting of a first and a second transistor, T11 and T12 for arm 1, T21 and T22 for arm 2. Transistors T11, T21 of of first and second arms 1, 2 respectively are diode-connected type PNP bipolar transistors, that is transistors having their base and collector connected together by means of corresponding resistances R3, R4 which are intrinsic to the integrated structure in Figure 1. The emitters of transistors T11, T21 are both connected to a negative potential output terminal A1 and the collectors are connected at circuit nodes N1, N2 to the emitters of second transistors T12, T22 of the first and second arm respectively. The latter are diode-connected type NPN bipolar transistors, that is transistors having their base and emitter connected together by means of corresponding resistances R1, R2 intrinsic to the integrated structure in Figure 1. The collectors of second transistors T12, T22 are connected to a positive potential output terminal K1.

In the embodiment of the bridge device in the form of a monolithic integrated circuit as in Figure 1 first parasitic transistors TP1a, TP1b and second parasitic transistors TP12, TP22 are formed.

First parasitic transistors TP1a, TP1b are lateral type PNP bipolar transistors, second parasitic transistors TP12, TP22 are vertical type PNP bipolar transistors.

The bases of transistors TP1a, TP1b are formed respectively by epitaxial layer 4 and region 19 located between regions 5 and 6, the emitter of transistor TP1a and the collector of transistor TP1b are formed in region 5, the collector of transistor TP1a and the emitter of transistor of TP1b are formed in region 6.

The bases of second parasitic transistors TP12, TP22 are formed in regions 7, 8 respectively, the emitters in regions 9, 10 and the collectors in regions 5, 6.

Returning now the circuit diagram in Figure 2, parasitic transistors TP1a, TP1b are illustrated with their bases connected together and to positive potential output terminal K1.

The collector of parasitic transistor TP1a is connected to the emitter of parasitic transistor TP1b and the base of transistor T12 of arm 1.

The emitter of parasitic transistor TP1a is connected to the collector of parasitic transistor TP1b and the base of transistor T22 of arm 2.

Parasitic transistors TP12, TP22 respectively have their emitters connected to negative potential output terminal A1, their respective collectors connected to the bases of transistors T12, T22, their bases connected to intermediate nodes N1, N2 between the collectors and the emitters respectively of transistors T11 and T12, T21 and T22, and to alternating current inputs A3, A4.

While diode-connected transistors T12, T21 are conducting (VA3, voltage at terminal A3, much greater than VA4, the voltage at terminal A4), the main factors responsible for conduction losses are parasitic components TP1b which cause the current from the input generator to recycle, and TP22 which causes transistor T22 to be activated reducing the output current available.

When the supply potential is reversed (i.e. when VA4 is much greater than VA3) a situation similar to the above arises in which parasitic components TP1a and TP12 are activated correspondingly.

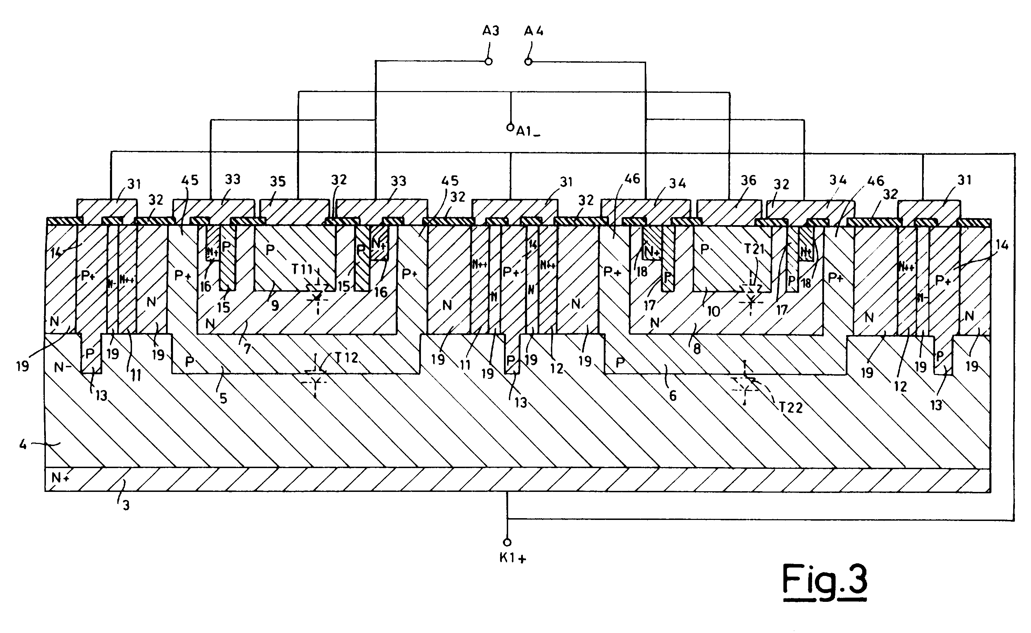

In order to overcome these disadvantages the integrated embodiment of the device according to the invention illustrated in Figure 3 has in addition to the regions already described with reference to Figure 1, within epitaxial layers 19 and 4, between regions 5, 6 and corresponding vertical flanks 45, 46, first type N++ regions 11, 12 to minimise the current gain of first parasitic transistors TP1a, TP1b and second type P and P+ regions 13, 14 recovering the residual loss currents from parasitic transistors TP1a, TP1b and inputting these to higher potential output K1.

Within region 7 there are type P regions 15 and type N+ regions 16.

Within region 8 there are type P regions 17 and type N+ regions 18.

Region 15 is capable of reducing the current passed to region 5, 45 coinciding with the base of transistor T12, and the anode of the equivalent diode provided by T12, so as to minimise the lateral effect of parasitic transistor TP12.

Region 17 is capable of reducing the current passed to region 6, 46 coinciding with the base of transistor T22, and also the anode of the equivalent diode provided by T21, so as to minimise the lateral effect of parasitic transistor TP22.

The vertical effect of parasitic transistors TP12 and TP22 is reduced by doping regions 5, 6 more heavily in such a way as to reduce the effect of parasitic resistances R1 and R2.

The surface of the device is covered with oxide 32 outside the regions providing the metal connections.

In particular there are metal connections 31 connecting regions 11, 12, 14 to positive potential terminal K1, a metal connection 33 connecting all regions 45, 15, 16 to input A3, a metal connector 34 connecting all regions 46, 17, 18 to input A4, and metal connectors 35, 36 connecting regions 9, 10 to negative potential output terminal A1.

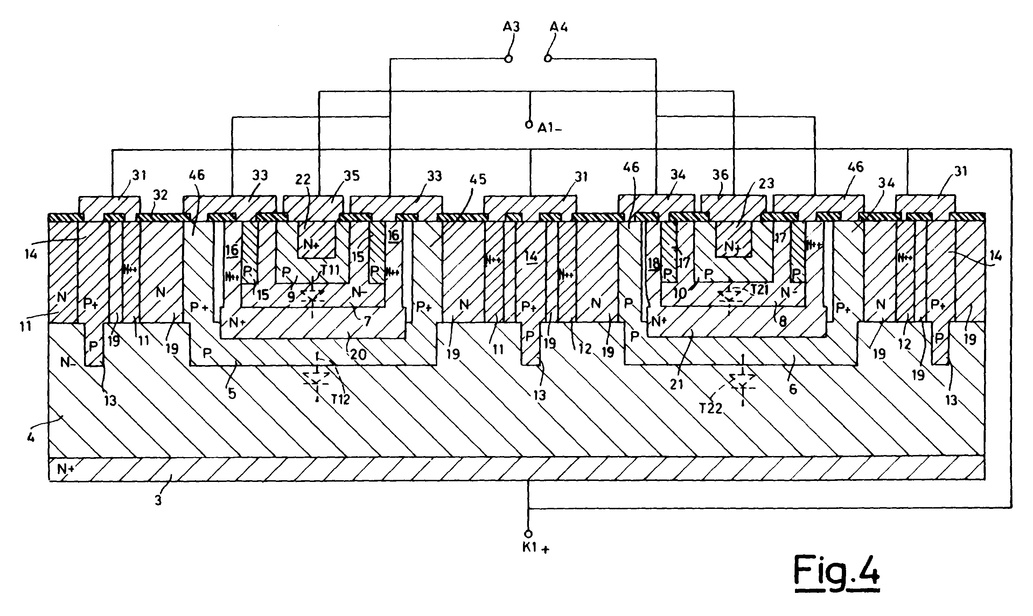

Figure 4 differs from Figure 3 in that regions 16, 18 extend at depth in horizontal layers 20, 21 so as to reduce the vertical component of the gain of parasitic transistors TP22, TP12. The lateral components of the said gains are reduced by means of regions 16, 18.

Within regions 9, 10 there are regions 22, 23 which improve the conversion efficiency of diode-connected transistors T11, T21.

Region 22 and regions 9, 7 and 20 form the emitter, base and collector junctions of a type NPN vertical flow transistor capable of increasing the rate of switching of diode-connected transistor T11.

The same may be said of region 23 together with regions 10, 8 and 21 in respect of diode-connected transistor T21.

Metal connectors 35, 36 also connect regions 22, 23 to negative potential terminal A1.

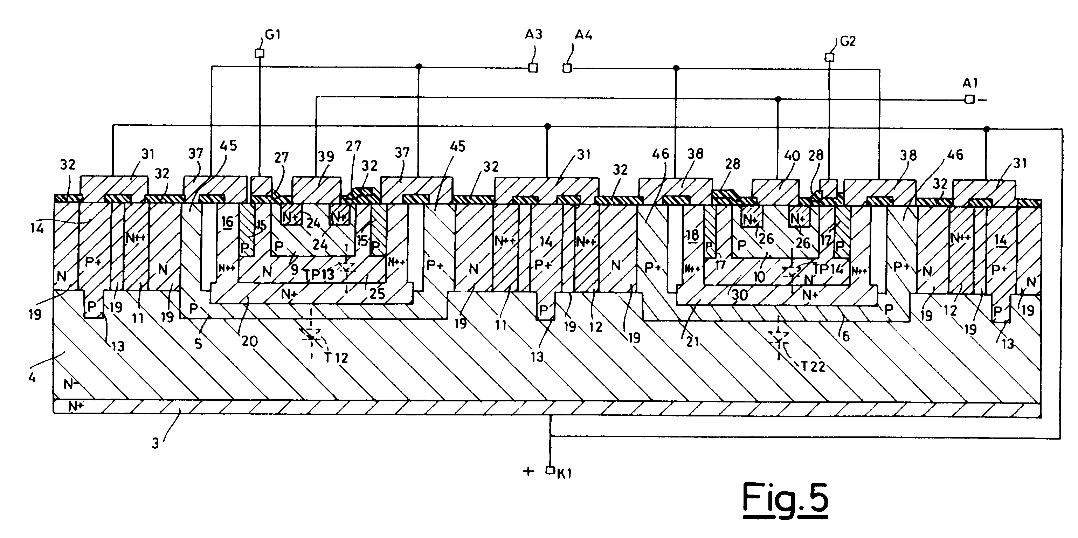

Figure 5 shows a mixed bipolar-MOS integrated embodiment of the device according to the invention.

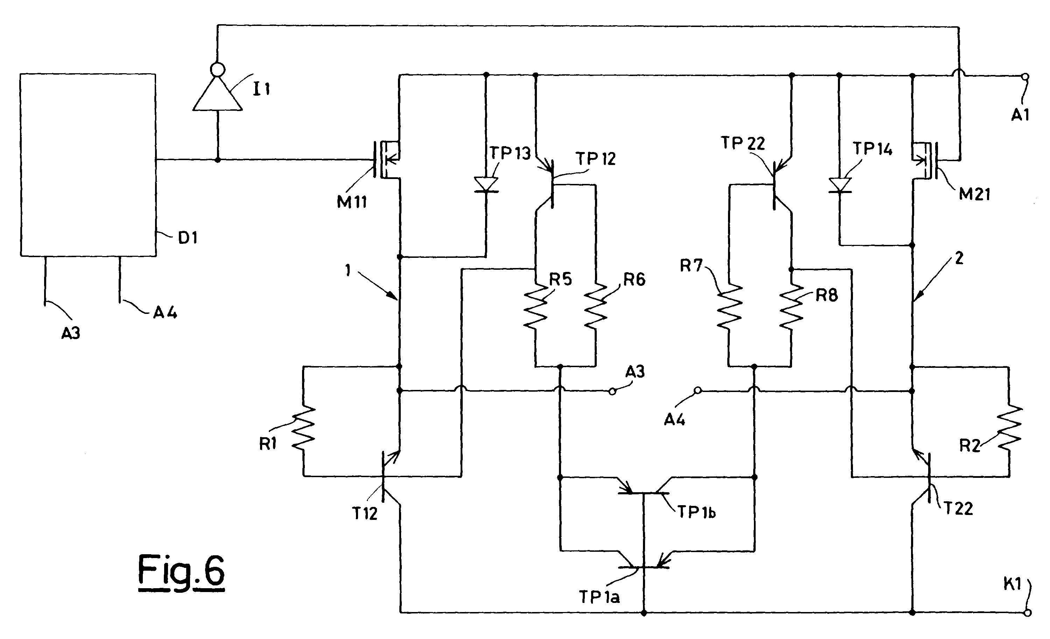

Its equivalent electrical circuit illustrated in Figure 6 differs from that in Figure 2 essentially in that vertical current flow MOS transistors M11, M21 are present and an isolated drain replaces bipolar transistors T11, T12.

Transistors M11, M22 are controlled at the gates directly and through an inverter I1 of a piloting or driver device D1 which uses known techniques to cause M11 or M21 respectively to conduct measuring the difference VA3-VA4 in the input voltages of the inverter circuit respectively. The sources of transistors M11, M22 are connected to output A1, the drains to the emitters of transistors T12, T22.

In the monolithic integrated embodiment in Figure 5 parasitic transistors TP1a, TP1b, TP12, TP22, shown in the equivalent electrical diagram in Figure 6 form, and their effects are reduced by means of the techniques previously described.

The emitter of transistor TP1b is connected to the collector of transistor TP1a and through intrinsic resistances R5, R6 respectively to the collector and base of parasitic transistor TP12.

The collector of transistor TP1b is connected to the emitter of transistor TP1a and through intrinsic resistances R7, R8 respectively to the base and collector of parasitic transistor TP22.

In the integrated embodiment further diode-connected bipolar parasitic transistors TP13, TP14 placed between the source and the drain of corresponding MOS M11, M21 form. The anodes of the equivalent diodes formed by parasitic transistors TP13, TP14 are connected to the sources of MOS M11, M21, the cathodes to the drains of the said MOS.

With reference to Figure 5, this differs from Figure 4 in the presence of regions corresponding to MOS M11, M21 and parasitic transistors TP13, TP14, and in the absence of regions 22, 23.

MOS M11 is formed by type N+ source regions 24 contained within region 9 forming the body.

The drain is formed by a weakly doped region 25 and enriched region 20. The gate is a region 27 embedded in the insulator. The gate electrode is indicated by G1.

MOS M21 is formed by type N+ type source regions 26 located within region 10 forming the body.

The drain is formed of a weakly doped region 30 and an enriched region 21. The gate is a region 28 embedded in the insulator. The gate electrode is indicated by G2.

Regions 9, 12 represent the base connected to the emitter and the collector of parasitic transistor TP13.

Regions 10, 21 represent the base connected to the emitter and the collector of parasitic transistor TP14.

Instead of metal connectors 33, 34, 35, 36 there are metal connectors 37, 38 which connect all regions 45, 16 and 46, 18 to corresponding inputs A3, A4 and metal connectors 39, 40 connecting all regions 9, 24 and 10, 26 to negative potential terminal A1.

In this circuit the low drain-source resistance associated with transistors M11, M21, when these are conducting, brings about a drastic reduction in the voltage drop at the junctions of diode-connected transistors TP13, TP14. The effect of parasitic transistors TP12, TP22 is not taken into consideration as it is drastically reduced by the said structure forming the MOS.

Driving of the device is adequate to avoid simultaneous conduction of M11 and M21 so that the conversion efficiency loss due to TP12, TP22 in the configuration in Figure 2 is reduced; the system thus forms an asynchronous detector.

Drive circuit D1 does not require further supply voltages because the drive voltage for gates G1, G2 may be less than that available on terminal K1.

The structures to which the invention relates, in all their embodiment configurations, can be used in multiphase circuits, and the bridge arms can vary from a minimum of 2 to N.

The maximum convertible power and the total number of unit arms which can be integrated are linked with the dimensions of the plate used.

If desired the same monolithic structure may also include one or more further type P, P+ regions such as 5, 45 connected to a potential which is not greater than the potential of substrate 3. One or more components of the control and drive device for the two arms of the bridge are housed in the said further regions.

## Claims

1. An integrated bridge device structure with at least a first (1) and a second (2) bridge arm each arm being formed of a first diode-connected PNP or MOS vertical transistor (T11, T21; M11, M21) and a second diode-connected NPN vertical transistor (T12, T22) connected in series, comprising an N+ substrate (3) forming a positive potential output terminal (K1) of the bridge, an N- epitaxial layer (4) formed on the substrate (3), further laterally spaced N epitaxial regions (19) of an N epitaxial layer formed on the N-epitaxial layer (4) and, for each bridge arm (1; 2) a P type region (5, 45; 6, 46), each P type region having a U-shaped cross section composed of a buried p region (5;6) representing a base region of said NPN vertical transistor and formed in said N-epitaxial layer (4) between said epitaxial regions (19) and further composed of P⁺ flanks extending from the surface of the N epitaxial layer to said buried p region (5;6), each P type region containing an N region (7; 8) which in turn contains a further P region (9, 10) forming a negative potential output terminal (A1) of the bridge, wherein type N++ regions (11, 12) are arranged in a first N epitaxial region (19) between the P type region of the first bridge arm (5,45) and the p type region (6,46) of the second bridge arm to minimize the current gain of any parasitic transistors (TP1a, TP1b) formed between said P type regions (5, 45; 6, 46) and through said first N epitaxial region (19).

2. A structure according to claim 1, characterised in that second regions (13, 14) of type P and P+ respectively recovering the residual current loss from said parasitic transistors (TP1a, TP1b) are also present between said P type regions (5, 45; 6, 46).

3. A structure according to claim 1, characterised in that in the N region (7, 8) contained within the P type region (5, 45; 6, 46) of each arm (1,2) there is a P region (15, 17) capable of reducing the current inputted into the P type region (5, 45; 6, 46) to reduce the effects of a further parasitic transistor (TP12; TP22) having a base formed in the N region (7; 8) contained between the P+ flanks (45, 46), a collector formed in the P+ flanks, and an emitter formed in the further P region (9; 10) connected to the negative potential output terminal (A1).

4. A structure according to claim 3, characterised in that the buried P region (5; 6) of each arm (1, 2) of the bridge is heavily doped.

5. A structure according to claim 3, characterised in that between the buried P region (5, 45; 6, 46) and the overlying N region (7; 8) of each arm (1,2) there is located a type N+ region (20; 21) capable of reducing the vertical component of the gain of said further parasitic transistor (TP12; TP22), said type N+ region (20; 21) extending to the structure surface of the N epitaxial layer in a pair of type N++ regions (16; 18) capable of reducing the lateral components of the gain of said further parasitic transistor (TP12; TP22).

6. A structure according to claim 5, characterised in that a type N+ region (22; 23) is located within the further P region (9; 10) connected to negative potential output terminal (A1), said type N+ region and further P region (9, 22; 10, 23) together with the underlying type N+ region (20; 21) representing the emitter, base and collector of a vertical current flow transistor capable of improving the conversion efficiency of said first diode connected PNP transistor (T11; T21) of each arm.

7. A structure according to claim 1, characterised in that the first transistor of each arm (1, 2) is a MOS type transistor (M11; M21) with a vertical current flow and an isolated drain formed from a pair of source regions (24; 26) of type N+ embedded in the further P region (9; 10) connected to the negative potential output terminal (A1) and type N and N+ drain regions (25, 20; 30, 21) contained in the p-type regions (5, 45; 6, 46).

8. A structure according to claim 1, characterised in that it comprises a plurality of arms to form a multiphase circuit.

9. A structure according to claim 7, characterised in that it comprises further type P, P+ regions (5, 45) formed in said epitaxial layers (4, 19) and adapted to be connected to a potential which is not greater than the potential of the substrate (3) to house the components of a control and drive device for the two arms (1, 2) of the bridge.

## Revendications

1. Structure intégrée de dispositif en pont comportant au moins un premier (1) et un second (2) bras de pont, chaque bras étant constitué d'un premier transistor vertical PNP ou MOS connecté en diode (T11, T21 ; M11, M21) et d'un second transistor vertical NPN connecté en diode (T12, T22) connectés en série, comprenant un substrat de type N⁺ (3) constituant une borne de sortie de potentiel positif (K1) du pont, une couche épitaxiale de type N⁻ (4) formée sur le substrat (3), des régions épitaxiales (19) de type N espacées latéralement d'une couche épitaxiale de type N formée sur la couche épitaxiale N⁻ (4) et, pour chaque bras de pont (1 ; 2), une région de type P (5, 45 ; 6, 46), chaque région de type P ayant une section en U constituée d'une région enterrée P (5 ; 6) constituant une région de base du transistor vertical NPN et formée dans la couche épitaxiale N⁻ (4) entre les régions épitaxiales (19) et constituée en outre de flancs P⁺ s'étendant à partir de la surface de la couche épitaxiale N vers la région enterrée P (5 ; 6), chaque région de type P contenant une région N (7 ; 8) qui contient elle-même une autre région P (9, 10) formant une borne de sortie de potentiel négatif (A1) du pont, dans laquelle des régions (11, 12) de type N⁺⁺ sont disposées dans une première région épitaxiale N (19) entre la région de type P du premier bras de pont (5, 45) et la région de type P (6, 46) du second bras de pont pour rendre minimum le gain en courant de tout transistor parasite (TP1a, TP1b) formé entre les régions de type P (5, 45 ; 6, 46) avec la première région épitaxiale N (19).

2. Structure selon la revendication 1, caractérisée en ce que les secondes régions (13, 14) de type P et P⁺ récupérant respectivement la perte de courant résiduel en provenance des transistors parasites (TP1a, TP1b) sont également présentes entre les régions de type P (5, 45 ; 6, 46).

3. Structure selon la revendication 1, caractérisée en ce que, dans la région N (7, 8) contenue dans la région de type P (5, 45 ; 6, 46) de chaque bras (1, 2), se trouve une région P (15, 17) propre à réduire le courant envoyé dans la région de type P (5, 45 ; 6, 46) pour réduire les effets d'un autre transistor parasite (TP12 ; TP22) ayant une base formée dans la région N (7 ; 8) contenue entre les flancs P⁺ (45, 46), un collecteur formé dans le flanc P⁺, et un émetteur formé dans l'autre région P (9 ; 10) connectée à la borne de sortie de potentiel négatif (A1).

4. Structure selon la revendication 3, caractérisée en ce que la région P enterrée (5 ; 6) de chaque bras (1, 2) du pont est fortement dopée.

5. Structure selon la revendication 3, caractérisée en ce que, entre la région enterrée P (5, 45 ; 6, 46) et la région N de recouvrement (7 ; 8) de chaque bras (1, 2), est disposée une région (20 ; 21) de type N⁺ propre à réduire la composante verticale de gain de l'autre transistor parasite (TP12 ; TP22), la région de type N⁺ (20 ; 21) s'étendant vers la surface de la structure de la couche épitaxiale N selon une paire de régions (16 ; 18) de type N⁺⁺ propre à réduire les composantes latérales du gain de l'autre transistor parasite (TP12 ; TP22).

6. Structure selon la revendication 5, caractérisée en ce qu'une région de type N⁺ (22 ; 23) est disposée dans l'autre région P (9 ; 10) connectée à la borne de sortie de potentiel négatif (A1), la région de type N⁺ et l'autre région (9 ; 22 ; 10, 23) prises ensemble avec la région sous-jacente de type N⁺ (20 ; 21) représentant l'émetteur, la base et le collecteur d'un transistor à flux de courant vertical propre à améliorer le rendement de conversion du premier transistor PNP connecté en diode (T11 ; T21) de chaque bras.

7. Structure selon la revendication 1, caractérisée en ce que le premier transistor de chaque bras (1, 2) est un transistor de type MOS (M11 ; M21) avec un flux de courant vertical et un drain isolé constitué d'une paire de régions de sources (24 ; 26) de type N⁺ logées dans l'autre région P (9 **;** 10) connectées à la borne de sortie de potentiel négatif (A1) et des régions de drains de type N et N⁺ (25, 20 ; 30, 21) contenues dans les régions de type P (5, 45 ; 6, 46).

8. Structure selon la revendication 1, caractérisée en ce qu'elle comprend plusieurs bras pour former un circuit polyphasé.

9. Structure selon la revendication 7, caractérisée en ce qu'elle comprend en outre des régions de type P et P⁺ (5, 45) formées dans lesdites couches épitaxiales (4, 19) et propres à être connectées à un potentiel non supérieur au potentiel du substrat (3) pour contenir les composants d'un dispositif de commande et d'alimentation pour les deux bras (1, 2) du pont.

## Patentansprüche

1. Integrierter Brückeneinrichtungsaufbau mit zumindest einem ersten (1) und einem zweiten (2) Brückenarm, wobei jeder Arm aus einem ersten diodengeschalteten vertikalen PNP- oder MOS-Transistor (T11, T21; M11, M21) und aus einem zweiten diodengeschalteten vertikalen NPN-Transistor (T12, T22), die in Reihe geschaltet sind, gebildet ist,
einem N⁺-Substrat (3), das einen positiven Potentialausgabeanschluß (K1) der Brücke bildet, einer N⁻-Epitaxieschicht (4), die auf dem Substrat (3) gebildet ist, weiter mit seitlich mit einem Abstand voneinander angeordneten N-Epitaxiebereichen (19) einer N-Epitaxieschicht, die auf der N⁻-Epitaxieschicht (4) gebildet ist, und einem P-Typ-Bereich (5, 45; 6, 46) für jeden Brückenarm (1; 2), wobei jeder P-Typ-Bereich einen U-förmigen Querschnitt aufweist, der aus einem vergrabenen P-Bereich (5; 6), der einen Basisbereich des vertikalen NPN-Transistors darstellt, gebildet ist, und in der N⁻-Epitaxieschicht (4) zwischen den Epitaxiebereichen (19) gebildet ist und weiter aus P⁺-Flanken, die sich von der Oberfläche der N-Epitaxieschicht bis zu dem vergrabenen P-Bereich (5; 6) erstrecken, gebildet ist, wobei jeder P-Typ-Bereich einen N-Bereich (7; 8) enthält, der wiederum einen weiteren P-Bereich (9, 10), der einen negativen Potentialausgabeanschluß (A1) der Brücke bildet, enthält,
wobei N⁺⁺-Typ-Bereiche (11, 12) in einem ersten N-Epitaxiebereich (19) zwischen dem P-Typ-Bereich des ersten Brückenarmes (5, 45) und dem P-Typ-Bereich (6, 46) des zweiten Brückenarmes derart angeordnet sind, daß die Stomverstärkung von jedem parasitären Transistor (TP1a, TP1b), die zwischen den P-Typ-Bereichen (5, 45; 6, 46) und durch den ersten N-Epitaxiebereich (19) gebildet sind, minimiert wird.

2. Aufbau nach Anspruch 1, dadurch gekennzeichnet, daß zweite Bereiche (13, 14) des P- und P⁺-Typs, die jeweils den Reststromverlust von den parasitären Transistoren (TP1a, TP1b) zurückgewinnen, auch zwischen den P-Typ-Bereichen (5, 45; 6, 46) vorhanden sind.

3. Aufbau nach Anspruch 1, dadurch gekennzeichnet, daß in dem N-Bereich (7, 8), der innerhalb des P-Typ-Bereiches (5, 45; 6, 46) von jedem Arm (1, 2) enthalten ist, ein P-Bereich (15, 17) vorhanden ist, der zum Reduzieren des in den P-Typ-Bereich (5, 45; 6, 46) eingegebenen Stromes derart fähig ist, daß die Effekte eines weiteren parasitären Transistors (TP12; TP22), der eine in dem N-Bereich (7; 8), der zwischen den P⁺-Flanken (45, 46) enthalten ist, gebildete Basis, einen in der P⁺-Flanke gebildeten Kollektor und einen in dem weiteren P-Bereich (9; 10), der mit dem negativen Potentialausgabeanschluß (A1) verbunden ist, gebildeten Emitter aufweist.

4. Aufbau nach Anspruch 3, dadurch gekennzeichnet, daß der vergrabene P-Bereich (5; 6) von jedem Arm (1, 2) der Brücke stark dotiert ist.

5. Aufbau nach Anspruch 3, dadurch gekennzeichnet, daß zwischen dem vergrabenen P-Bereich (5, 45; 6, 46) und dem oberhalb liegenden N-Bereich (7; 8) von jedem Arm (1, 2) ein N⁺-Typ-Bereich (20; 21) angeordnet ist, der zur Reduzierung der vertikalen Komponente der Verstärkung des weiteren parasitären Transistors (TP12; TP22) fähig ist, wobei der N⁺-Typ-Bereich (20, 21), der sich zu der Aufbauoberfläche der N⁻-Epitaxieschicht in einem Paar von N⁺⁺-Typ-Bereichen (16; 18) erstreckt, zur Reduzierung der seitlichen Komponenten der Verstärkung des weiteren parasitären Transistors (TP12; TP22) fähig ist.

6. Aufbau nach Anspruch 5, dadurch gekennzeichnet, daß ein N⁺-Typ-Bereich (22; 23) innerhalb des weiteren P-Bereiches (9; 10), der mit dem negativen Potentialausgabeanschluß (A1) verbunden ist, angeordnet ist, wobei der N⁺-Bereich und ein weiterer P-Bereich (9, 22; 10, 23) zusammen mit dem unterhalb liegenden N⁺-Tpy-Bereich (20; 21) den Emitter, Basis und Kollektor eines Transistors mit vertikalem Stromfluß, der fähig ist, den Umwandlungswirkungsgrad des ersten diodengeschalteten PNP-Transistors (T11; T21) von jedem Arm zu verbessern, darstellen.

7. Aufbau nach Anspruch 1, dadurch gekennzeichnet, daß der erste Transistor von jedem Arm (1, 2) ein MOS-Typ-Transistor (M11; M21) mit einem vertikalen Stromfluß und einem getrennten Drain ist, der aus einem Paar von Source Bereichen (24; 26) des N⁺-Typs, die in dem weiteren P-Bereich (9; 10), der mit dem negativen Potentialausgabeanschluß (A1) verbunden ist, eingebettet sind und N- und N⁺-Typ-Drain-Bereichen (25, 20; 30, 21), die in den P-Typ-Bereichen (5, 45; 6, 46) enthalten sind, gebildet ist.

8. Aufbau nach Anspruch 1, dadurch gekennzeichnet, daß er eine Mehrzahl von Armen so aufweist, daß eine Mehrphasenschaltung gebildet wird.

9. Aufbau nach Anspruch 7, dadurch gekennzeichnet, daß er weiter P-, P⁺-Typ-Bereiche (5, 45), die in den Epitaxieschichten (4, 19) gebildet sind und so angepaßt sind, daß sie mit einem Potential, das nicht größer ist als das Potential des Substrates (3), verbunden sind, so aufweist, daß die Komponenten einer Steuer- und Treibereinrichtung für die zwei Arme (1, 2) der Brücke aufgenommen werden.
